# EUROPEAN PATENT APPLICATION

(11) **EP 1 898 241 A1**
(43) Date of publication of application: **12.03.2008**
(21) Application number: 06780623.2
(22) Date of filing: 13.06.2006
(51) Int. Cl.: G02B 7/02, G03F 7/20, H01L 21/027

(54) **OPTICAL ELEMENT, OPTICAL ELEMENT HOLDING APPARATUS, EXPOSURE APPARATUS AND DEVICE MANUFACTURING METHOD**

(30) Priority: 14.06.2005 JP 2005173340
(71) Applicant: NIKON CORPORATION, Tokyo 100-8331 (JP)
(72) Inventor: OKADA, Takaya, NIKON CORPORATION, Tokyo 100-8331 (JP); SUGAWARA, Ryu, NIKON CORPORATION, Tokyo 100-8331 (JP)
(74) Representative: HOFFMANN EITLE
(86) International application number: PCT/JP2006/311825
(87) International publication number: WO 2006/134910

(57) **Abstract**

An optical element (LS2) has, in a side face (T6), a groove portion (50) for insertion of a portion of an optical element holding device.

## Description

### TECHNICAL FIELD

This invention relates to an optical element, an optical element holding device, an exposure apparatus, and a device manufacturing method.

Priority is claimed on Japanese Patent Application No. 2005-173340, filed June 14, 2005, the contents of which are incorporated herein by reference.

### BACKGROUND ART

When using a holding device to hold a lens or other optical element used in the optical system of exposure apparatuses and various other optical equipment, often ridge portions, protruding from a side face of the optical element, is held (See Patent Reference 1).
Patent Reference 1: Japanese Patent Application, Publication No. 2001-74991 (corresponding to U.S. Patent No. 6,239,924)

### DISCLOSURE OF INVENTION

### PROBLEMS TO BE SOLVED BY THE INVENTION

In order to have the holding device adequately hold a ridge portion protruding from a side face of an optical element, the ridge portion must be formed with a prescribed size in the optical element radial direction and thickness direction. However, from the standpoint of element surface grinding tasks, the outside diameter and thickness of an optical element having the ridge portion are determined uniquely by the curvature of the optical element surface. For example, in the case of an optical element the center thickness of which is extremely thick compared with the peripheral thickness, in order to secure the ridge portion which can be adequately held by a holding device, the optical element must be made larger in the outside-diameter and thickness directions. For this reason, optical elements are increased in size, and so there is the possibility of problems arising as optical equipment overall becomes larger.

The present invention has been made in view of such circumstances, and it is a purpose of the present invention to provide an optical element which can be held satisfactorily while suppressing deformation, as well as an optical element holding device to hold the optical element. Another purpose is to provide an exposure apparatus which uses a satisfactorily held optical element to expose a substrate, and a device manufacturing method.

### MEANS FOR SOLVING THE PROBLEM

In order to achieve these objects, the present invention employs the following configurations summarized below in conjunction with the drawings that illustrate embodiments. In this regard, reference numerals in parentheses are attached to individual elements merely for the purpose of illustration and are not intended to limit the respective elements.

According to a first aspect of the invention, in an optical element the peripheral portion of which is held by a holding member (100), an optical element (LS2) is provided in which a groove portion (50) for insertion of a portion of the holding member (100) is formed in a side face (T6) of the optical element (LS2).

By means of the first aspect of the invention, the groove portion for insertion of the portion of the holding member is provided in the side face of the optical element, so that satisfactory holding is possible without enlarging the optical element. Furthermore, there is no protruding portion protruding from the side face, so that grinding treatment and other prescribed treatment of the optical element can be performed smoothly.

According to a second aspect of the invention, in an optical element holding device having a holding member which holds a peripheral portion of an optical element (LS2), an optical element holding device (LH) is provided, in which the optical element (LS2) has a groove portion (50) formed in a side face (T6), and the holding member has a first support portion (101) which supports the optical element (LS2), and a second support portion (102) which is inserted into the groove portion (50), and which moreover clamps a portion of the optical element (LS2) together with the first support portion (101).

By means of this second aspect of the invention, satisfactory holding is possible while suppressing deformation of the optical element.

According to a third aspect of the invention, in an exposure apparatus which irradiates a substrate (P) with exposure light (EL) via optical elements (LS1 to LS7) to expose the substrate (P), an exposure apparatus (EX) is provided which uses as optical elements the optical elements of the above aspects.

By means of this third aspect, a substrate can be satisfactorily exposed using satisfactorily held optical elements.

According to a fourth aspect of the invention, a device manufacturing method is provided which uses the exposure apparatus (EX) of the above aspect.

By means of this fourth aspect of the invention, devices can be manufactured using an exposure apparatus which can satisfactorily expose substrates.

### EFFECTS OF THE INVENTION

According to the present invention, optical elements can be held satisfactorily. Further, a satisfactorily held optical element can be used to satisfactorily expose a substrate.

### BRIEF DESCRIPTION OF THE DRAWINGS

FIG. 1 is a side cross-sectional view showing the optical element of a first aspect.
FIG. 2 is a plane view showing the optical element of the first aspect.
FIG 3 is a perspective view showing the optical element of the first aspect.
FIG. 4 is a drawing used to explain the holding member of the first aspect.
FIG. 5 is a schematic diagram showing the manner of grinding treatment of the upper face of an optical element.
FIG. 6A shows the optical element of a second aspect.
FIG. 6B shows the optical element of the second aspect.
FIG 7 is a drawing used to explain the holding member of a third aspect.
FIG. 8 shows the optical element of a fourth aspect.
FIG. 9 shows the optical element of a fifth aspect.
FIG 10 shows the optical element of a sixth aspect.
FIG 11 is a drawing used to explain the holding member of a seventh aspect.
FIG. 12 shows in summary the configuration of one aspect of an exposure apparatus.
FIG. 13 is a flowchart used to explain an example of microdevice manufacturing processes.

### DESCRIPTION OF THE REFERENCE SYMBOLS

50 : GROOVE PORTION, 50A: FIRST GROOVE PORTION, 50B: FIRST GROOVE PORTION, 56 : RIM PORTION, 100 : HOLDING DEVICE (OPTICAL ELEMENT HOLDING DEVICE), 101 : FIRST SUPPORT PORTION, 102 : SECOND SUPPORT PORTION, 122 : ATTACHMENT STRUCTURE (FIRST SUPPORT PORTION), 134 : SUPPORT PLATE (FIRST SUPPORT PORTION), AX : OPTICAL AXIS, EL : EXPOSURE LIGHT, EX : EXPOSURE APPARATUS, LH : OPTICAL ELEMENT HOLDING DEVICE, LQ : LIQUID, LS1: FIRST OPTICAL ELEMENT, LS2 : OPTICAL ELEMENT (SECOND OPTICAL ELEMENT), P : SUBSTRATE, PL : PROJECTION OPTICAL SYSTEM, T3 : LOWER FACE (EMISSION FACE), T4 : UPPER FACE (INCIDENCE FACE), T6 : SIDE FACE

### BEST MODE FOR CARRYING OUT THE INVENTION

Below, embodiments of the invention are explained referring to the drawings; however, the invention is not limited to these embodiments. In the following explanations, an XYZ orthogonal coordinate system is set in the drawings, and the positional relations of members are explained in reference to this XYZ orthogonal coordinate system. Moreover, rotation (inclination) directions about the X-axis, Y-axis, and Z-axis are taken to be θX, θY, and θZ, respectively. The XY plane is a horizontal plane, and the Z axis is an axis in the vertical or plumb direction.

### <First Embodiment>

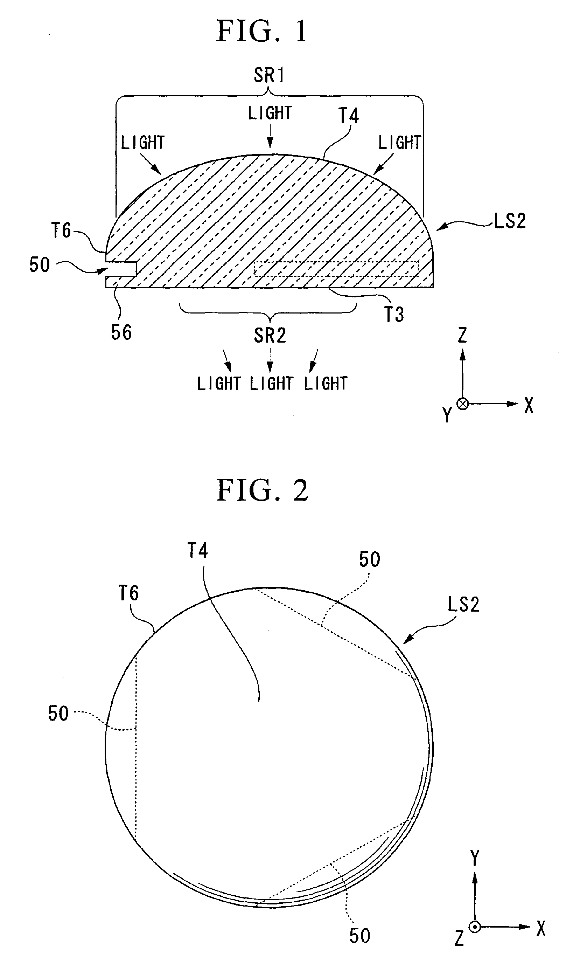

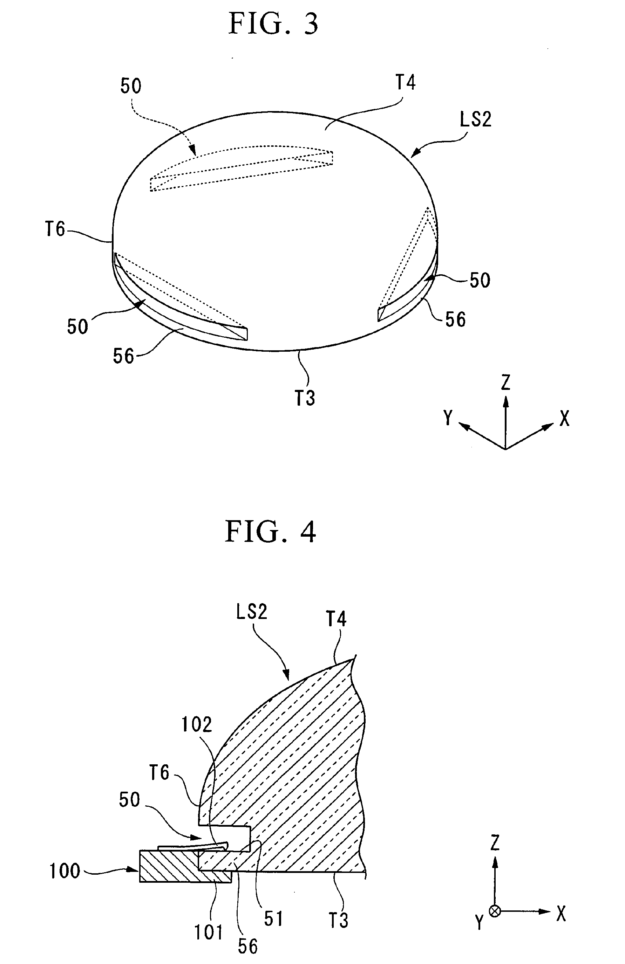

A first embodiment is explained referring to FIG. 1 through FIG 4. FIG 1 is a side cross-sectional view showing the optical element LS2 of the first embodiment; FIG. 2 is a plane view of the optical element LS2; and FIG. 3 is a perspective view of the optical element LS2. FIG. 4 shows a state in which the optical element LS2 is being held by a holding member (optical element holding device) 100.

The peripheral portion of the optical element LS2 is held by the holding member 100. That is, groove portions 50 are formed in the side face T6 of the body of the optical element LS2, for insertion of a portion of the holding member 100. As shown in FIG. 2, the optical element LS2 of this embodiment is substantially disc-shaped in plane view, and a plurality of groove portions 50 are formed in the side face T6 along tangential directions of the optical element LS2. In this embodiment, groove portions 50 are formed in three places in the side face T6 of the optical element LS2, along tangential directions of the optical element LS2.

The optical element LS2 has an upper face on which light is incident (incidence face) T4, and a lower face from which incident light is emitted (emission face) T3. As shown in FIG. 1, the upper face T4 is formed in an arc shape in cross-sectional view so as to be distended upward, and is substantially spherical. On the other hand, the lower face T3 is substantially flat. That is, the optical element LS2 is an optical element having refractive power (lens action), and is configured having an upper face T4 with a spherical-shape and having a planer lower face T3, the upper surface T4 being formed to be convex upward and having positive refractive power.

The side face T6 may be a face continuous with the upper face T4, that is, may have the same curvature as the upper face T4. Or, whereas the upper face T4 has a curvature, the side face T6 may have a flat face.

As shown in FIG. 4, an optical element holding device (holding member) 100 has a first support portion 101, which holds the optical element LS2, and a second support portion 102, which is inserted into the groove portion 50, and which moreover clamps the rim portion 56 of the optical element LS2 with the first support portion 101. The first support portion 101 is positioned on the side of the lower face T3 of the optical element LS2, and supports the lower face T3 of the optical element LS2.

The second support portion 102 is in contact with the first face 51 facing in the +Z direction among the inside faces of the groove portion 50. The second support portion 102 has an elastic member such as for example a leaf spring member or similar, and is elastically deformable. A rim portion 56 is formed between the first face 51 and the lower face T3; the second support portion 102 and the first support portion 101 clamp the rim portion 56 of the optical element LS2.

A plurality of (three) optical element holding devices 100 are provided, corresponding to the plurality of (three) groove portions 50. As shown in FIG. 1, light irradiates a prescribed region (first region) SR1 on which light is incident among the upper face T4, and after passing through the optical element LS2, is emitted from a prescribed region (second region) SR2 of the lower face T3. The optical element holding devices 100 and groove portions 50 are provided in a prescribed region (third region) which does not block the passing light.

That is, the third region is provided in a region differing from the first region and the second region. Hence this third region is a region which is the region of the upper face T4 other than the first region, and the region of the lower face T3 other than the second region. In this embodiment, as one example, it is assumed that the third region includes the side face T6.

As explained above, groove portions 50 for insertion of a portion of an optical element holding device 100 are provided in the side face T6 of the optical element LS2, so that the optical element LS2 can be satisfactorily held by the optical element holding device 100 while suppressing deformation of the optical element LS2. That is, the groove portions 50 are formed at positions at which the passage of light is not obstructed, without providing protruding portions which protrude from the side face T6 of the optical element LS2, so that the position and size of the groove portions 50 can be adjusted and the thickness of the rim portion 56 can be made large; hence the optical element LS2 can be satisfactorily held by optical element holding devices 100 while suppressing deformation of the optical element LS2. Further, in this embodiment a plurality of groove portions 50 are formed along the tangential direction of the side face T6 of the optical element LS2, and in the optical element LS2, regions other than regions in which the groove portions 50 are formed is relatively thick, so that overall strength of the optical element LS2 can be maintained. Further, when holding by the optical element holding devices 100, deformation (strain) of the upper face T4 and lower face T3 of the optical element LS2 can be effectively suppressed.

Because there are no protruding portions protruding from the side face T6 of the optical element LS2, the optical element LS2 can be made more compact. Hence there can be enhanced freedom of design and placement of the optical element LS2 and optical element holding devices 100 which hold the element, or of any peripheral equipment or members positioned on the periphery of the optical element LS2 and optical element holding devices 100.

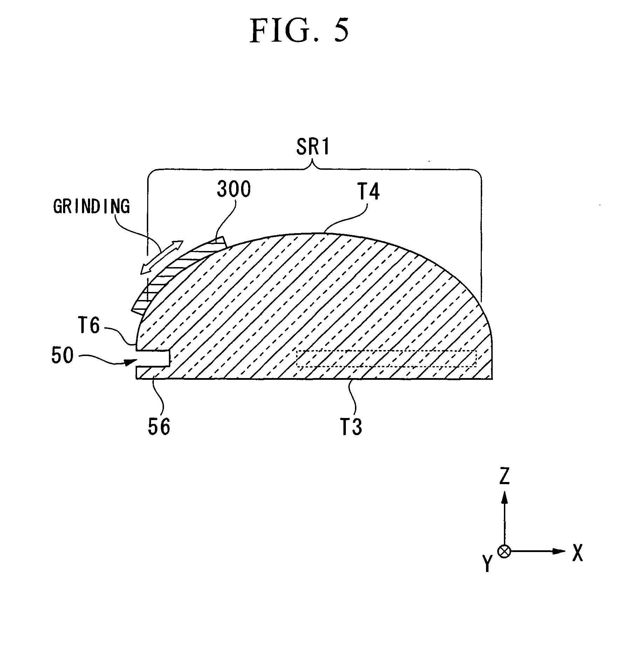

Further, because there are no protruding portions protruding from the side face T6 of the optical element LS2, even when using a grinding machine 300 to grind the upper face T4, grinding can be performed satisfactorily up to the edge portion of the first region SR1, as for example shown in FIG. 5. When a protruding portion (rim portion) is provided on the side face T6 of the optical element LS2 protruding from the side face T6, there is interference between the protruding portion and the grinding machine 300, and a problem may occur due to which satisfactory grinding up to the edge portion of the first region SR1 is not possible. In order to perform grinding up to the edge portion of the first region SR1, a configuration is possible in which the protruding portion (rim portion) is made small, but because the strength of the protruding portion (rim portion) is reduced, when a holding member is used to hold the protruding portion (rim portion), there is the possibility that deformation of the optical element having the protruding portion (rim portion) may occur. In this embodiment, a protruding portion is not provided on the side face T6 of the optical element LS2, so that grinding treatment can be performed satisfactorily up to the edge portion of the first region SR1. In this case, even if the first region SR1 is set extending to the vicinity of a groove portion 50, that is, the first region SR1 is set in most of the region of the upper face T4 which is a spherical surface, satisfactory grinding can be performed up to the edge portion of the first region SR1. Moreover, because there are no protruding portions, in addition to grinding treatment, prescribed treatments of the optical element LS2 other than grinding can also be performed smoothly. Similarly, treatments of the lower face T3 of the optical element LS2 can also be performed smoothly. In this way, the surfaces of the optical element LS2 can be treated satisfactorily, so that an optical element LS2 having satisfactory optical characteristics can be manufactured.

In this embodiment, three groove portions 50 are formed along tangential directions in the side face T6 of the optical element LS2; but the number of groove portions can be set arbitrarily.

### <Second Embodiment>

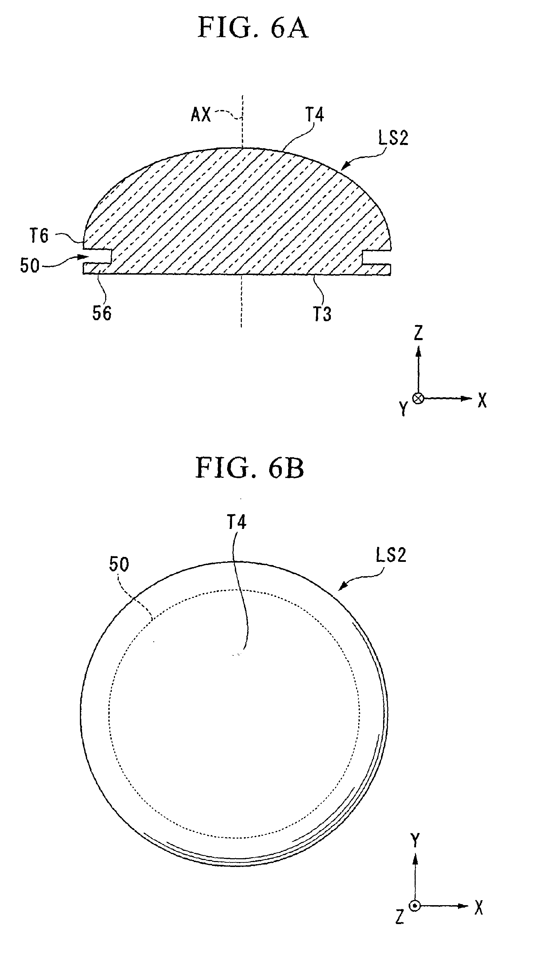

Next, a second embodiment is explained referring to FIG. 6A and FIG. 6B. FIG 6A is a side cross-sectional view showing the optical element LS2 of the second embodiment; FIG. 6B is a plane view. In the following explanation, constituent portions which are the same as or similar to portions in the above-described embodiment are assigned the same symbols, and explanations are simplified or omitted.

As shown in FIG. 6A and FIG. 6B, a groove portion 50 is formed in a ring shape in the side face T6 of the optical element LS2, so as to surround the optical axis AX. In this embodiment, the optical axis AX is parallel to the Z-axis direction. In this way, a groove portion 50 can be formed so as to surround the optical axis AX. In this case, the positions and number of optical element holding devices 100 can be set arbitrarily. By adjusting the position and size of the groove portion 50, there is no need to provide a protruding portion protruding from the side face T6 of the optical element LS2, the thickness of the rim portion 56 can be increased, and the optical element LS2 can be held satisfactorily by the optical element holding devices 100 while suppressing deformation of the optical element LS2.

### <Third Embodiment>

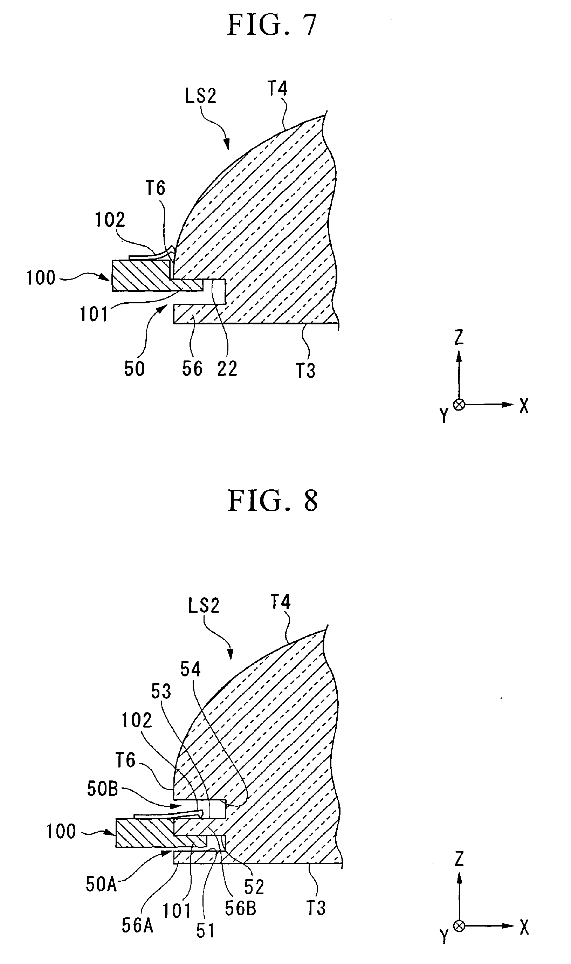

Next, a third embodiment is explained referring to FIG 7. As shown in FIG. 7, a first support portion 101 of an optical element holding device 100 is inserted into a groove portion 50 formed in the side face T6 of the optical element LS2. Also, a second support portion 102 of the optical element holding device 100 is positioned on the side of the upper face T4 of the optical element LS2. The first support portion 101 supports the second face 22 facing the -Z side among the inner faces of the groove portion 50. The second support portion 102 is in contact with a portion of the upper face T4 of the optical element LS2. Together with the first support portion 101, the second support portion 102 clamps a portion of the optical element LS2. In this way, the first support portion 101 is inserted into the groove portion 50, and the second support portion 102 can be positioned on the side of the upper face T4.

### <Fourth Embodiment>

Next, a fourth embodiment is explained referring to FIG 8. In FIG. 8, a plurality of groove portions are formed in the side face T6 of the optical element LS2, arranged in the direction parallel to the optical axis (the Z-axis direction), separated by a prescribed distance. In this embodiment, the optical element LS2 has a first groove portion 50A and a second groove portion 50B, formed in the side face T6 and separated by a prescribed distance in the Z-axis direction. The first groove portion 50A is formed on the -Z side (lower side) of the second groove portion 50B. Similarly to the above first embodiment, a plurality of (three) first and second groove portions 50A, 50B respectively are formed in the side face T6 of the optical element LS2. And, a first rim portion 56A is formed between the lower face T3 and the first groove portion 50A, while a second rim portion 56B is formed between the first groove portion 50A and the second groove portion 50B.

In an optical element holding device 100, the first support portion 101 is inserted into the first groove portion 50A, and the second support portion 102 is inserted into the second groove portion 50B, and together with the first support portion 101 clamps the second rim portion 56B of the optical element LS2. The first support portion 101 supports the second face 52 facing in the -Z direction among the inside faces of the first groove portion 50A. On the other hand, the second support portion 102 is positioned on the side of the third face 53 facing in the +Z direction among the inner faces of the second groove portion 50B, and is in contact with the third face 53. In this way, groove portions 50 (50A, 50B) can also be formed in a plurality of positions along the Z-axis direction in the side face T6 of the optical element LS2.

In the fourth embodiment, the lower face T3 of the optical element LS2 may be supported by the first support portion 101 of the optical element holding device 100, and the second support portion 102 may be inserted into the first groove portion 50A and brought into contact with the first face 51, so that the first rim portion 56A is clamped by the first support portion 101 and second support portion 102. Or, the first support portion 101 of the optical element holding device 100 may be inserted into the second groove portion 50B, and the first support portion 101 may support the fourth face 54 facing in the -Z direction among the inner faces of the second groove portion 50B, with the second support portion 102 brought into contact with a portion of the upper face T4 of the optical element LS2.

Or, a plurality of optical element holding devices 100 may be provided arranged in the Z-axis direction. For example, a first rim portion 56A may be clamped by the first support portion and second support portion of a first holding member, and a second rim portion 56B may be clamped by the first support portion and second support portion of a second holding member.

In the fourth embodiment, an explanation has been given in which a plurality of each of the first and second groove portions 50A, 50B are formed along the tangential direction of the side face T6 of the optical element LS2; but similarly to the above-described second embodiment, the first and second groove portions 50A, 50B may each be formed in a ring shape surrounding the optical axis. Or, a plurality of one among the first groove portion 50A and second groove portion 50B may be formed along the tangential direction, while the other is formed in a ring shape surrounding the optical axis.

In this embodiment, the optical element LS2 has two groove portions 50A, 50B formed in the side face T6 separated by a prescribed distance in the direction parallel to the optical axis; however, an arbitrary number of groove portions 50, such as three or four, may be formed.

### <Fifth Embodiment>

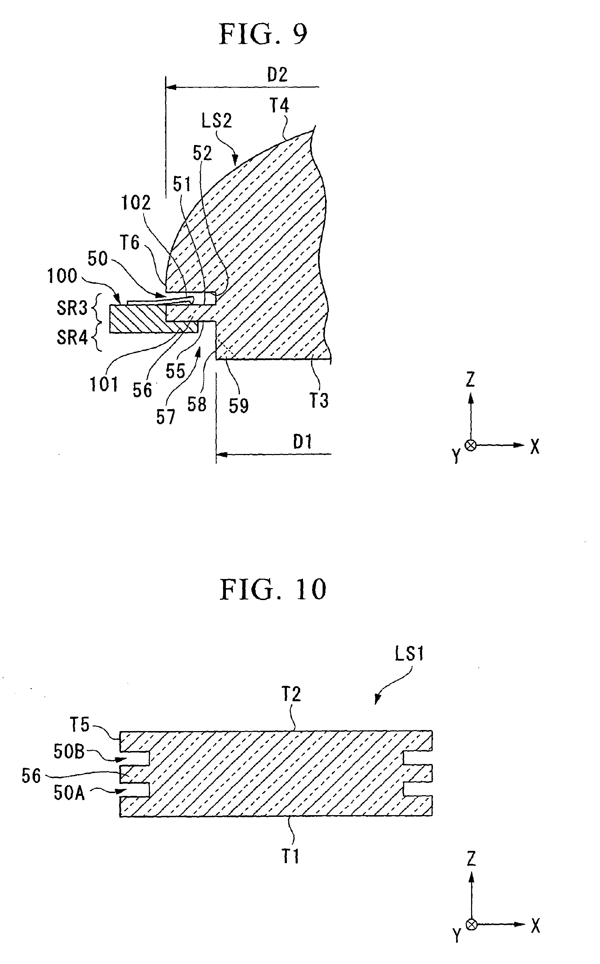

Next, a fifth embodiment is explained referring to FIG. 9. In FIG. 9, groove portions 50 is formed in the side face T6 of the optical element LS2. Similarly to the above first embodiment, a plurality of (three) groove portions 50 are formed along the tangential direction of the side face T6 of the optical element LS2.

In this embodiment, the outside diameter D1 of the lower face T3 is formed to be smaller than the outside diameter D2 of the upper face T4. And, the side face T6 has a groove portion 50, as well as a third region SR3 having an outer diameter substantially equal to the outer diameter D2 of the upper face T4, and a fourth region SR4 having an outer diameter substantially equal to the outer diameter of the lower face T3. Between the third region SR3 and the fourth region SR4 is formed a step portion. In the following explanation, of the side face T6, the fourth region SR4, which is recesses toward the optical axis compared with the third region SR3, is called the "depressed portion 57" as appropriate.

The optical element LS2 has a fifth face 55 facing in the -Z direction, formed by the depressed portion 57, and a sixth face 58 facing in the -X direction. And, a rim portion 56 is formed between the first face 51 on the inside of the groove portion 50 and the fifth face 55. Of the optical element holding device 100, the first support portion 101 supports the fifth face 55. The second support portion 102 is inserted into the groove portion 50, and moreover clamps the rim portion 56 of the optical element LS2 together with the first support portion 101. In this embodiment, a plurality of groove portions 50 are formed along the tangential direction, similarly to the first embodiment, and the strength of the optical element LS2 is maintained.

By thus providing the depressed portion 57, the region on the lower side of the rim portion 56 can be made comparatively broad, so that, for example, there is a greater degree of freedom in placement of peripheral equipment or members positioned on the periphery of the optical element LS2.

Further, in the sixth embodiment, the groove portion 50 may be formed in a ring shape surrounding the optical axis.

Further, in the sixth embodiment, the angle portion 59 at which the sixth face 58 and the lower face T3 intersect may be chamfered or cut.

### <Sixth Embodiment>

Next, a sixth embodiment is explained referring to FIG 10. In the above-described first through fifth embodiments, the upper face T4 of the optical element LS2 is spherical in shape, but as shown in FIG. 10, the optical element may for example be a parallel-plane plate.

In FIG. 10, the upper face T2 of the optical element LS1 is substantially planar, and the lower face T1 is also substantially planar. Further, the upper face T2 and lower face T1 are substantially parallel. Light is incident on the upper face T2, and after passing through the optical element LS1, is emitted from the lower face T1.

Similarly to the above-described fourth embodiment, the optical element LS1 has a first groove portion 50A and second groove portion 50B formed in the side face T5, separated by a prescribed distance in the Z-axis direction. The rim portion 56 formed between the first groove portion 50A and second groove portion 50B is clamped by the first support portion 101 and second support portion 102 of an optical element holding device 100.

In the sixth embodiment, a plurality of the first and second groove portions 50A, 50B may each be formed along the tangential direction of the side face T5 of the optical element LS1; the first and second groove portions 50A, 50B may each be formed in a ring shape surrounding the optical axis; or, one among the first groove portion 50A and second groove portion 50B may be formed as a plurality of groove portions along the tangential direction, while the other is formed in a ring shape so as to surround the optical axis.

In the sixth embodiment, similarly to the above first embodiment, one groove portion 50 may be provided in the Z-axis direction in the side face T5 of the optical element LS1. Also, in the sixth embodiment, similarly to the above fifth embodiment, the outer diameter of the upper face T2 and the outer diameter of the lower face T1 may be made different, with a depressed portion formed in a portion of the side face T5.

### <Seventh Embodiment>

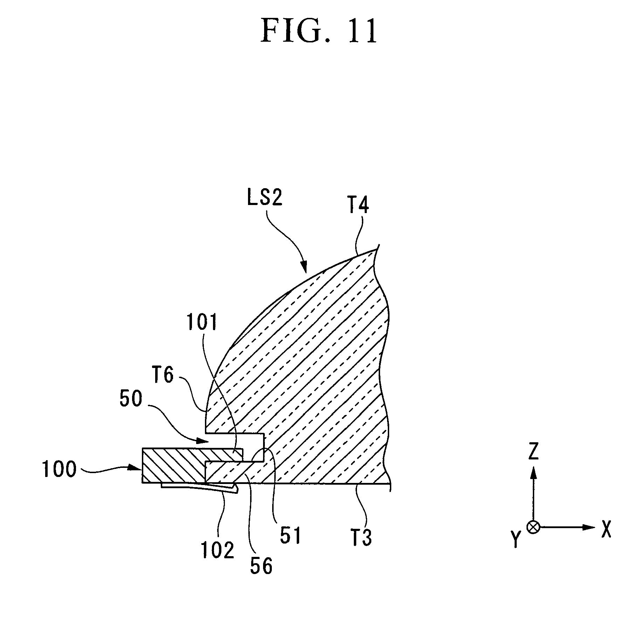

Next, a seventh embodiment is explained referring to FIG. 11. In the above-described first through sixth embodiments, the first support portion 101 supports a face of the optical element LS2 (rim portion) facing in the -Z direction, and the second support portion 102 supports a face of the optical element LS2 (rim portion) facing in the +Z direction; but as shown in FIG. 11, the second support portion 102 may support a face of the optical element LS2 (rim portion) facing in the -Z direction, and the first support portion 101 may be in contact with a face of the optical element LS2 (rim portion) facing in the +Z direction.

In FIG 11, a groove portion 50 is formed in the side face T6 of the optical element LS2 to enable insertion of a portion of the optical element holding device 100. And, of the optical element holding device 100, the first support portion 101 is inserted into the groove portion 50. Among the inside faces of the groove portion 50, the first support portion 101 is in contact with the first face 51 facing in the +Z direction. The second support portion 102 is positioned on the side of the lower face T3 of the optical element LS2, and supports the lower face T3 of the optical element LS2. And, by means of the first support portion 101 and second support portion 102, the optical element holding device 100 clamps the rim portion 56 of the second optical element LS2.

In the above first through seventh embodiments, a holding member holds an optical element LS2 by using a first support portion and second support portion to clamp a portion of the side face of the optical element LS2; however, for example bonding, using an adhesive or similar, between the optical element and at least one among the first support portion and the second support portion, may also be performed. Or, a suction-holding portion may be provided on at least one among the first support portion and the second support portion, to perform suction-holding of the optical element. Or, a bolt member or similar may be used between the optical element and at least one among the first support portion and the second support portion to perform connection. Also, in each of the above-described embodiments, the shapes of groove portions are not limited to linear shapes, but curved shapes or any other arbitrary shapes may be used, so long as the passage of light is not obstructed.

Further, the outer shape of the optical element may be circular, elliptical, or a shape obtained by cutting a portion of the outer perimeter of a circular shape to form a linear portion.

Moreover, in the above embodiments, configurations were explained in which the lower face of the optical element is a planar face; but the face may have a curvature (concave or convex).

As the material used to form the first support portion, various materials, such as metals, ceramics, silicon, glass (for example, quartzite glass or fluorite), can be used.

### <Exposure Apparatus>

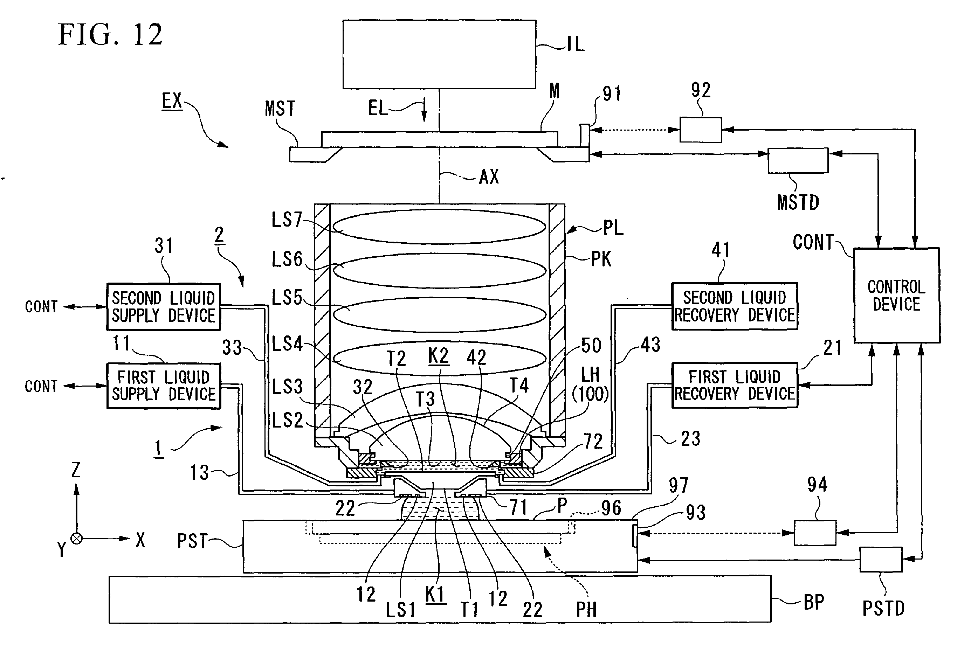

Next, an embodiment of an exposure apparatus is explained. FIG 12 is a summary configuration diagram showing an embodiment of an exposure apparatus EX. In FIG. 12, the exposure apparatus EX has a mask stage MST, which holds a mask M and is capable of motion; a substrate stage PST, having a substrate holder PH which holds a substrate P, and which can move the substrate holder PH holding the substrate P; an illumination optical system IL, which illuminates a mask M being held by the mask stage MST with exposure light EL; a projection optical system PL, which projects a pattern image of the mask M illuminated by the exposure light EL onto the substrate P being held by the substrate stage PST; and, a control device CONT, which controls operations of the entire exposure apparatus EX.

The exposure apparatus EX of this embodiment is a liquid immersion exposure apparatus in which a liquid immersion method is applied in order to effectively shorten the exposure light wavelength and improve resolution as well as effectively enlarging the focal depth, and has a first liquid immersion mechanism 1 to fill with a liquid LQ a first space K1, which is the optical path space of exposure light EL between the substrate P and a first optical element LS1, which is the optical element closest to the image plane of the projection optical system PL among the plurality of optical elements LS1 to LS7 used in the projection optical system PL. The substrate P is positioned on the image-plane side of the projection optical system PL (first optical element LS 1), and the lower face T1 of the first optical element LS1 is positioned so as to oppose the surface of the substrate P. The first liquid immersion mechanism 1 is provided in proximity to the first space K1, and has a first nozzle member 71, having a supply port 12 which supplies liquid LQ and a recovery port 22 which recovers liquid LQ; a first liquid supply device 11, which supplies liquid LQ via the supply tube 13 and the supply port 12 provided in the first nozzle member 71; and a first liquid recovery device 21, which recovers liquid LQ via the recovery port 22 provided in the first nozzle member 71 and the recovery tube 23. Above the substrate P (substrate stage PST), the first nozzle member 71 is formed in a ring shape so as to enclose the lower portion of the first optical element LS1 among the plurality of optical elements employed in the projection optical system PL. Operation of the first liquid immersion mechanism 1, having the first liquid supply device 11 and first liquid recovery device 21, is controlled by the control device CONT.

The exposure apparatus EX further has a second liquid immersion mechanism 2, to fill with liquid LQ a second space K2 which is the optical path space of the exposure light EL between the first optical element LS1, and the second optical element LS2 closest to the image plane of the projection optical system PL after the first optical element LS1. The second optical element LS2 is positioned above the first optical element LS1, and the upper face T2 of the first optical element LS1 is positioned so as to be opposed to the lower face T3 of the second optical element LS2. The second liquid immersion mechanism 2 is provided in the vicinity of the second space K2, and has a second nozzle member 72, having a supply port 32 which supplies liquid LQ and a recovery port 42 which recovers liquid LQ; a second liquid supply device 31, which supplies liquid LQ via the supply tube 33 and the supply port 32 provided in the second nozzle member 72; and, a second liquid recovery device 41, which recovers liquid LQ via the recovery port 42 provided in the second nozzle member 72 and the recovery tube 43. Above the first nozzle member 71, the second nozzle member 72 is formed in a ring shape so as to enclose the upper portion of the first optical element LS1 among the plurality of optical elements employed by the projection optical system PL. In this embodiment, the first optical element LS1 is supported by the second nozzle member 72.

The liquid LQ supplied by the first liquid immersion mechanism 1 is held between the first optical element LS1 and the substrate P positioned on the image-plane side thereof, and the liquid LQ supplied by the second liquid immersion mechanism 2 is held between the upper face T2 of the first optical element LS1 and the lower face T3 of the second optical element LS2. At least which the pattern image of the mask M is being projected onto the substrate P, the exposure apparatus EX uses the first liquid immersion mechanism 1 to fill the first space K1 between the first optical element LS 1 and the substrate P with liquid LQ, and uses the second liquid immersion mechanism 2 to fill the space K2 between the first optical element LS1 and the second optical element LS2 with liquid LQ.

In this embodiment, the exposure apparatus EX adopts a local immersion method in which a liquid immersion region of liquid LQ, larger than the projection region and smaller than the substrate P, is formed locally on a portion of the substrate P which is the projection region of the projection optical system PL. Further, in this embodiment the exposure apparatus EX forms a liquid immersion region of liquid LQ is formed in a region which is a prescribed region through which the exposure light EL passes, on the upper face T2 of the first optical element LS1. The exposure apparatus EX projects the pattern of the mask M onto the substrate P by irradiating the substrate P with exposure light EL which has passed through the mask M, via the projection optical system PL having the first and second optical elements LS1 and LS2, the liquid LQ filling the second space K2, and the liquid LQ filling the first space K1.

Further, the exposure apparatus EX of this embodiment is a scanning-type exposure apparatus (a so called scanning stepper) which exposes the substrate P to a pattern formed on the mask M while synchronously moving the mask M and the substrate P in the scanning direction (for example, the Y-axis direction). Here, a "substrate" may be a semiconductor wafer or other substrate onto which has been applied a photosensitive material (resist), and a "mask" may be a reticle on which is formed the device pattern to be reduced and projected onto the substrate.

The illumination optical system IL has a light source for exposure, an optical integrator to render uniform the illuminance of the beam emitted from the exposure light source, a condenser lens to condense the exposure light EL from the optical integrator, a relay lens system, a field stop to set the illumination region on the mask M by the exposure light EL, and similar. A prescribed illumination region on the mask M is illuminated with exposure light EL with a uniform illuminance distribution by means of the illumination optical system IL. As the exposure light EL emitted from the illumination optical system IL, for example, emission lines emitted from a mercury lamp (the g line, h line, i line), as well as KrF excimer laser light (wavelength 248 nm) and other deep-ultraviolet (DUV) light, as well as ArF excimer laser light (wavelength 193 nm), F₂ laser light (wavelength 157 nm), and other vacuum ultraviolet (VUV) light is used. In this embodiment, ArF excimer laser light is used.

In the embodiment, pure water (purified water) is used as the liquid LQ. Pure water is capable of transmitting not only ArF excimer laser light, but also deep-ultraviolet light (DUV) such as the bright lines (the g-ray, h-ray, and i-ray) emitted from a mercury lamp and the like, and KrF excimer laser light (248 nm wavelength).

The mask stage MST can move holding the mask M. The mask stage MST holds the mask M by means of vacuum clamping (or electrostatic clamping). While holding the mask M, the mask stage MST can move within the plane perpendicular to the optical axis AX of the projection optical system PL, that is, can move in two dimensions within the XY plane, and can rotate minute amounts in the θZ direction, by means of driving by a mask stage driving device MSTD having a linear motor controlled by the control device CONT. A movable mirror 91 is provided on the mask stage MST. Moreover, a laser interferometer 92 is provided at a prescribed position. The position in two dimensions of the mask M on the mask stage MST, and the rotation angle in the θZ direction (including, in some cases, rotation angles in the θX and θY directions also), are measured in real-time by the laser interferometer 92. Measurement results of the laser interferometer 92 are output to the control device CONT. The control device CONT drives the mask stage driving device MSTD based on measurement results of the laser interferometer 92, and performs position control of the mask M being held by the mask stage MST.

The projection optical system PL projects the pattern of the mask M, positioned in a first plane (the object plane), onto the surface of the substrate P, positioned in a second plane (the image plane), with a prescribed projection magnification β, to perform exposure, and has a plurality of optical elements LS1 to LS7, including a first optical element LS1 which is positioned most closely to the image plane of the projection optical system PL. When projecting the pattern of the mask M onto the substrate P, exposure light EL passes through the projection optical system PL. In this embodiment, the projection optical system PL is a reduction system in which the projection magnification P is, for example, 1/4, 1/5, or 1/8. The projection optical system PL may also be an equal system or an enlarging system.

The first optical element LS1 is a parallel-plane plate with no refractive power which is capable of passing the exposure light EL; the lower face T1 and upper face T2 are parallel. The first optical element LS1 is supported by a second nozzle member 72. The second nozzle member 72 is a frame member enclosing the first optical element LS1, and has a support portion which supports the outer perimeter (flange portion) of the first optical element LS1; the first optical element LS1 is supported by a support member provided on the second nozzle member 72. The second nozzle member 72 supporting the first optical element LS1 is connected to the lower edge (lower face) of the barrel PK. The second nozzle member 72 supporting the first optical element LS1 is provided so as to enable attachment to and detachment from the barrel PK.

The second optical element LS2 is an optical element having refractive power (lens action), and has a planar lower face T3 and an upper face T4, formed in a convex shape facing toward the object plane (mask M), and has positive refractive power. The upper face T4 of the second optical element LS2 has positive refractive power, so that reflection losses of light (exposure light EL) incident on the upper face T4 are reduced, and hence a large image-side numerical aperture is secured.

In this embodiment, among the plurality of optical elements LS1 to LS2 used in the projection optical system PL, a groove portion 50 is provided in the side face T6 of the second optical element LS2. And, an optical element holding device LH (holding member) is provided in a portion of the barrel PK to hold the second optical element LS2. The relation between the groove portion 50 and the optical element holding device LH is as explained in the first through seventh embodiments. The second optical element LS2, having a refractive power (lens action), is held by the holding device LH of the barrel PK in a satisfactorily positioned state. The lower face T3 of the second optical element LS2 held by the holding device LH and the upper face T2 of the first optical element LS1 supported by the second nozzle member 72 are substantially parallel.

The substrate stage PST has a substrate holder PH which holds the substrate P, the substrate holder PH can move while holding the substrate P. The substrate holder PH holds the substrate P by for example vacuum clamping or similar. A depressed portion 96 is provided on the substrate stage PST, and the substrate holder PH to hold the substrate P is placed in the depressed portion 96. The upper face 97 of the substrate stage PST outside the depressed portion 96 is a flat plane, at substantially the same height as (flush with) the surface of the substrate P held by the substrate holder PH. If it is possible to continuously fill the first space K1 with liquid LQ, then a step may be present between the upper face 97 of the substrate stage PST and the surface of the substrate P held by the substrate holder PH.

The substrate stage PST can move in two-dimensional directions in the XY plane on the base member BP and can rotate through minute angles in the θZ direction, while holding the substrate P via the substrate holder PH, by means of driving by the substrate stage driving device PSTD having a linear motor or similar controlled by the control device CONT. Further, the substrate stage PST can also move in the Z-axis direction, θX direction, and θY direction. Hence the surface of the substrate P held by the substrate stage PST can move with six degrees of freedom in the X-axis, Y-axis, Z-axis, θX, θY and θZ directions. A movable mirror 93 is provided on a side face of the substrate stage PST. Also, a laser interferometer 94 is provided at a prescribed position. The position in two directions and rotation angle of the substrate P on the substrate stage PST can be measured in real-time by the laser interferometer 94. Further, although not shown, the exposure apparatus EX further has a focusing/leveling detection system which detects plane position information for the surface of the substrate P held by the substrate stage PST.

Measurement results of the laser interferometer 94 and detection results of the focusing/leveling detection system are output to the control device CONT. The control device CONT drives the substrate stage driving device PSTD based on detection results of the focusing/leveling detection system, controls the focus position (Z position) and inclination angles (θX, θY) of the substrate P, and adjusts the positional relation between the surface of the substrate P and the image plane formed via the projection optical system PL and liquid LQ, as well as performing position control in the X-axis direction, Y-axis direction, and θZ direction of the substrate P, based on measurement results of the laser interferometer 94.

Next, the first liquid immersion mechanism 1 is explained. The first liquid supply device 11 of the first liquid immersion mechanism 1 supplies liquid LQ in order to fill the first space K1, which is the optical path space between the first optical element LS1 and the substrate P, with liquid LQ, and has a tank which accommodates liquid LQ, a pressurizing pump, a temperature adjustment device which adjusts the temperature of the liquid LQ supplied, and a filter unit which removes foreign matter in the liquid LQ. One end of the supply tube 13 is connected to the first liquid supply device 11, and the other end of the supply tube 13 is connected to the first nozzle member 71. Liquid supply operation of the first liquid supply device 11 is controlled by the control device CONT. The tank, pressurizing pump, temperature adjustment device, filter unit, and similar of the first liquid supply device 11 need not all be used in the exposure apparatus EX, and may be replaced with utilities in the plant or similar in which the exposure apparatus EX is installed.

The first liquid recovery device 21 of the first liquid immersion mechanism 1 recovers liquid LQ which is filling the first space K1, which is the optical path space between the first optical element LS1 and the substrate P, and has a vacuum system having a vacuum pump and similar, a gas-liquid separator which separates gas from recovered liquid LQ, a tank which accommodates recovered liquid LQ, and similar. One end of the recovery tube 23 is connected to the first liquid recovery device 21, and the other end of the recovery tube 23 is connected to the first nozzle member 71. Liquid recovery operation of the first liquid recovery device 21 is controlled by the control device CONT. The vacuum system, gas-liquid separator, tank, and similar of the first liquid recovery device 21 need not all be employed by the exposure apparatus EX, and may be replaced with utilities in the plant or similar in which the exposure apparatus EX is installed.

The supply port 12 which supplies liquid LQ to the first space K1 and the recovery port 22 which recovers liquid LQ in the first space K1 are formed in the lower face of the first nozzle member 71. The lower face of the first nozzle member 71 is provided at a position opposing the surface of the substrate P and the upper face 97 of the substrate stage PST. The first nozzle member 71 is a ring-shape or rectangular-shape member provided so as to surround the side face of the first optical element LS1; a plurality of supply ports 12 are provided, in the lower face of the first nozzle member 71, so as to surround the first optical element LS1 of the projection optical system PL (optical axis AX of the projection optical system PL). The recovery ports 22 are provided in the lower face of the first nozzle member 71 on the outside of (further from the supply ports 12 than) the supply ports 12 relative to the first optical element LS1, and are provided so as to surround the final optical element LS1 and supply ports 12.

The control device CONT supplies a prescribed amount of liquid LQ to the first space K1 using the first liquid supply device 11, and in addition recovers a prescribed amount of liquid LQ in the first space K1 using the first liquid recovery device 21; by this means, the first space K1, which is the optical path space of exposure light EL between the projection optical system PL and substrate P, is filled with liquid LQ. When filling the first space K1 with liquid LQ, the control device CONT drives both the first liquid supply device 11 and the first liquid recovery device 21. When, under control by the control device CONT, liquid is fed from the first liquid supply device 11, the liquid LQ fed from the first liquid supply device 11 flows through the supply tube 13, and then passes through the supply flow path formed within the first nozzle member 71 and is supplied from the supply ports 12 into the first space K1. Further, when under control by the control device CONT the first liquid recovery device 21 is driven, liquid LQ in the first space K1 passes through the recovery ports 22 and flows into the recovery flow path provided within the first nozzle member 71, and after flowing through the recovery tube 23, is recovered into the first liquid recovery device 21.

Next, the second liquid immersion mechanism 2 is explained. The second liquid supply device 31 of the second liquid immersion mechanism 2 supplies liquid LQ so as to fill with liquid LQ the second space K2, which is the optical path space between the upper face T2 of the first optical element LS1 and the lower face T3 of the second optical element LS2. The second liquid supply device 31 has a configuration substantially the same as that of the first liquid supply device 11 of the first liquid immersion mechanism 1. One end of the supply tube 33 is connected to the second liquid supply device 31, and the other end of the supply tube 33 is connected to the second nozzle member 72. Liquid supply operation of the second liquid supply device 31 is controlled by the control device CONT.

The second liquid recovery device 41 of the second liquid immersion mechanism 2 recovers liquid LQ in the second space K2. The second liquid recovery device 41 has substantially the same configuration as the first liquid recovery device 21 of the first liquid immersion mechanism 1. One end of the recovery tube 43 is connected to the second liquid recovery device 41, and the other end of the recovery tube 43 is connected to the second nozzle member 72. Liquid recovery operation of the second liquid recovery device 41 is controlled by the control device CONT.

Supply ports 32 to supply liquid LQ to the second space K2 and recovery ports 42 to recovery liquid LQ from the second space K2 are formed at prescribed positions in the second nozzle member 72. In this embodiment, a supply port 32 is provided at a prescribed position on the -X side of the second space K2 in the second nozzle member 72. A recovery port 42 is provided at the position opposing the supply port 32, with the second space K2 therebetween, in the second nozzle member 72.

When filling the second space K2 with liquid LQ, the control device CONT supplies a prescribed amount of liquid LQ using the second liquid supply device 31 of the second liquid immersion mechanism 2, and by this means fills the second space K2, which is the optical path space of exposure light EL between the first optical element LS1 and the second optical element LS2, with liquid LQ. When filling the second space K2 with liquid LQ, the control device CONT drives the second liquid supply device 31. When under control of the control device CONT liquid LQ is fed from the second liquid supply device 31, liquid LQ fed from the second liquid supply device 31 flows through the supply tube 33, and after passing through the supply flow path formed within the second nozzle member 72, is supplied from the supply port 32 to the second space K2. Further, when under control of the control device CONT the second liquid recovery device 41 is driven, liquid LQ in the second space K2 flows via the recovery port 42 into the recovery flow path formed within the second nozzle member 72, and after flowing through the recovery tube 43, is recovered into the second liquid recovery device 41.

When performing liquid immersion exposure of the substrate P, the control device CONT uses the first liquid immersion mechanism 1 and second liquid immersion mechanism 2 to fill both the first space K1 and second space K2 with liquid LQ. After filling the first space K1 and second space K2 with liquid LQ, the control device CONT illuminates the mask M, held by the mask stage MST, with exposure light EL by means of the illumination optical system IL. Exposure light EL irradiated from the illumination optical system IL passes through the mask M, and after passing through the plurality of optical elements LS7 to LS3, is incident on a prescribed region (first region SR1) of the upper face T4 of the second optical element LS2, passes through the second optical element LS2, and after passing through a prescribed region (second region SR2) of the lower face T3, is incident on the liquid LQ filling the second space K2. Exposure light EL which has passed through this liquid LQ passes through a prescribed region of the upper face T2 of the first optical element LS1, passes through a prescribed region of the lower face T1, and after being incident on the liquid LQ filling the first space K1, reaches the substrate P. By this means, liquid immersion exposure of the substrate P is performed.

In this embodiment, groove portions are provided in the second optical element LS2, and a holding device uses the groove portions to hold the second optical element LS2; groove portions may also be provided in the other optical elements (LS1, LS3 to LS7) used in the projection optical system PL. Also, the optical element holding device (holding member) can also use these groove portions to hold the optical elements (LS1, LS3 to LS7).

In the above-described embodiments, examples were explained in which the optical elements having groove portions were optical elements employed by a projection optical system PL mounted in an exposure apparatus EX; of course, groove portions can be provided in optical elements employed by optical systems other than projection optical systems PL (or exposure apparatuses EX), such as for example focusing/leveling detection systems and alignment microscopes, and in addition, these optical elements can be held by holding members (holding devices) of this invention.

The liquid immersion exposure apparatuses EX of the above embodiments employ pure water as the liquid LQ. Pure water can easily be acquired in large quantities in semiconductor device manufacturing facilities and similar, and has the further advantage of not exerting adverse effects on the photoresist on substrates P, optical elements (lenses), and similar. Further, pure water exerts no adverse effects on the environment, and has an extremely small impurity content, so that pure water can also be expected to act to clean the surface of the substrate P and the surface of the optical element provided as the end surface of the projection optical system PL.

The refractive index "n" of pure water (water) for exposure light EL of wavelength approximately 193 nm is regarded as approximately 1.44; hence when using ArF excimer laser light (wavelength 193 nm) as the light source of exposure light EL, high resolution is obtained, with the wavelength shortened to 1/n, or approximately 134 nm, at the substrate P. Further, the depth of focus is broadened by a factor of approximately n compared with the depth of focus in air, that is, by a factor of approximately 1.44, so that when it is sufficient to secure a depth of focus approximately the same as when used in air, the numerical aperture of the projection optical system PL can be further increased, and in this respect also resolution can be improved.

Furthermore, although the liquid LQ in the embodiment is water, it may be a liquid other than water; for example, if the light source of the exposure light EL is an F2 laser, then this F2 laser light will not transmit through water, so it would be acceptable to use as the liquid LQ a fluorine based fluid that is capable of transmitting F2 laser light, such as perfluorinated polyether (PFPE) or fluorine based oil. In addition, it is also possible to use as the liquid LQ a liquid (e.g., cedar oil) that is transparent to the exposure light EL, has the highest possible refractive index, and is stable with respect to the projection optical system PL and the photoresist coated on the front surface of the substrate P.

Further, as the liquid LQ, a liquid with a refractive index of 1.6 to 1.8 may be used. And, optical elements may be formed from a material with a higher refractive index than quartz or fluorite (for example 1.6 or higher).

The substrate P in the above embodiments is not limited to a semiconductor wafer for semiconductor device manufacturing, but may also be a glass substrate for display devices, a ceramic wafer for thin film magnetic heads, or the blank (synthetic quartz or silicon wafer) for a mask or reticle used in exposure apparatuses.

As the exposure apparatus EX, in addition to a step-and-scan type scanning exposure system (scanning stepper), in which the mask M and substrate P are moved synchronously and scanning exposure to the pattern of the mask M is performed, application to a step-and-repeat type projection exposure system (stepper), in which batch exposure to the pattern of the mask M is performed with the mask M and substrate P held stationary, and the substrate P is moved sequentially in steps, is also possible.

As the exposure apparatus EX, the invention can also be applied to an exposure system in which, with a first pattern and the substrate in substantially a stationary state, a reduced image of the first pattern is projected in batch exposure onto the substrate P using a projection optical system (for example a refractive projection optical system, not employing reflecting elements, with a 1/8 reducing magnification). In this case, application is also possible to a stitch-type batch exposure system in which thereafter, with a second pattern and the substrate P substantially stationary, the projection optical system is used to project the reduced image of the second pattern onto the substrate with partial overlapping with the first pattern. As the stitch-type exposure apparatus, application is also possible to a step-and-stitch type exposure system in which at least two patterns are transferred with partial overlapping onto the substrate P, and the substrate P is moved sequentially.

Further, this invention can also be applied to a twin-stage type exposure system having a plurality of substrate stages, such as have been disclosed in Japanese Patent Application, Publication No. H10-163099, Japanese Patent Application, Publication No. H10-214783, and Published Japanese Translation No. 2000-505958 of the PCT International Publication, and similar.

Also, this invention can also be applied to an exposure system, such as is disclosed in Japanese Patent Application, Publication No. H11-135400 and in Japanese Patent Application, Publication No. 2000-164504, having a substrate stage which holds substrates and reference members on which are formed reference marks, as well as a measurement stage on which are mounted various optoelectronic sensors.

In the above-described embodiments, an exposure apparatus is adopted in which there is local filling with liquid of the space between the projection optical system PL and the substrate P; however, this invention can also be applied to liquid immersion exposure apparatuses, such as disclosed in Japanese Patent Application, Publication No. H06-124873, Japanese Patent Application, Publication No. H10-303114, U.S. Patent No. 5,825,043, and similar, in which the entire surface of the substrate for exposure is immersed in a liquid during exposure.

In the above-described embodiments, explanations were given for an example of a liquid immersion exposure apparatus in which the optical path space of exposure light is filled with a liquid; however, this invention can also be applied to ordinary dry-type exposure apparatuses in which the optical path space of exposure light is filled with a gas.

The type of exposure apparatus EX is not limited to exposure apparatuses for semiconductor device manufacturing in which a substrate P is exposed to a semiconductor device pattern, and the invention can be broadly applied to exposure apparatuses for liquid crystal display element and display device manufacturing, to exposure apparatuses for manufacture of thin film magnetic heads, charge-coupled devices (CCDs), reticles and masks, and similar.

In the above-described embodiments, transmission-type masks are used in which a prescribed light-blocking pattern (or phase pattern, dimming pattern) is formed on a light-transmitting substrate; however, instead of such masks, electronic masks which form light-transmitting patterns or reflecting patterns based on electronic data of the pattern for exposure, as well as light-emitting patterns, such as disclosed for example in U.S. Patent No. 6,778,257, may be used.

Further, this application can also be applied to an exposure apparatus (lithograph system) which exposes a substrate P to a line-and-space pattern by forming interference fringes on the substrate P, as disclosed in PCT International Publication No. WO 2001/035168.

As explained above, an exposure apparatus EX of this application can be manufactured by assembling various subsystems, employing constituent elements within the scope of claims of this application, so as to maintain prescribed mechanical, electrical and optical precisions. In order to secure these various precisions, before and after assembly adjustments to each of the optical systems to attain the required optical precision, adjustments to each of the mechanical systems so as to attain the required mechanical precision, and adjustments to each of the electrical systems so as to attain the required electrical precision, are performed. The process of assembling the exposure apparatus from the various subsystems include mechanical connection, connection of electrical circuit wiring, connection of pipes between pressurized circuits, and similar between the various subsystems. Prior to the process of assembly of the exposure apparatus from the various subsystems, of course processes to assemble each of the subsystems are performed. When the process to assemble the exposure apparatus from the various subsystems is completed, comprehensive adjustments are performed, so that the various precisions are secured for the exposure apparatus as a whole. It is desirable that manufacture of the exposure apparatus be performed in a clean room in which temperature, cleanliness, and other parameters are controlled.

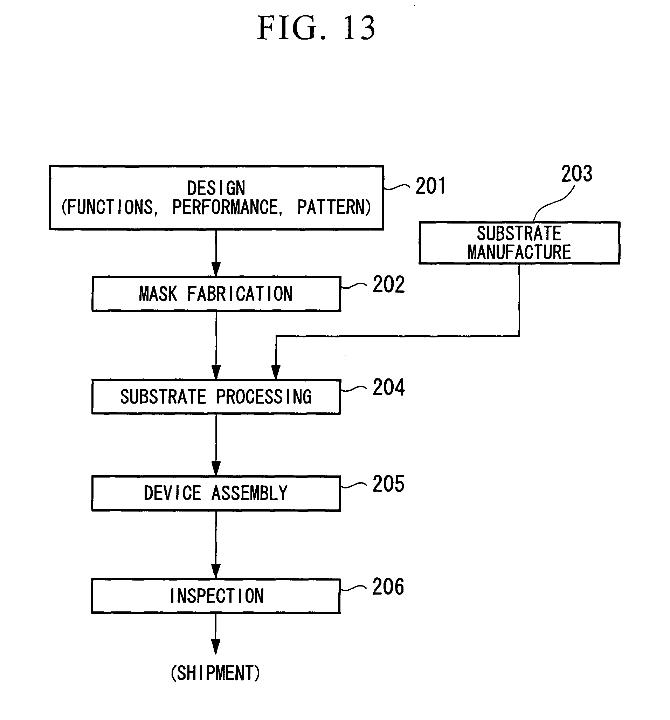

As shown in FIG. 13, semiconductor devices and other microdevices are manufactured by means of a step 201 of designing the functions and performance of a microdevice; a step 202 of manufacturing a mask (reticle) based on this design step; a step 203 of manufacturing the substrate which is the base member of the device; a step 204 of employing an exposure apparatus EX of an above-described embodiment to expose the substrate to the pattern of the mask; a step 205 of device assembly (including dicing, bonding, packaging, and other processes); and an inspection step 206.

## Claims

1. An optical element, comprising:
an element body having a peripheral portion held by a holding member; and,
a groove portion formed in a face of the element body different from a face having an incidence region of light and from a face having an emission region of the light, and into which a portion of the holding member is inserted.

2. The optical element according to Claim 1, wherein the groove portion has a plurality of groove elements formed along a tangential direction of the element body.

3. The optical element according to Claim 1, wherein the groove portion has a ring-shape groove element surrounding an optical axis.

4. The optical element according to any one of Claims 1 to 3, wherein the groove portion has a plurality of groove elements, mutually separated in a direction parallel to an optical axis.

5. An optical element holding device, comprising:
a holding member which holds an optical element having a groove portion formed in a peripheral portion of the holding member, wherein
the holding member has a first support portion, which supports the optical element, and a second support portion, inserted into the groove portion, and which together with the first support portion clamps a portion of the optical element.

6. The optical element holding device according to Claim 5, wherein
the optical element has an incidence face onto which light is incident and an emission face from which the incident light is emitted, and wherein
the first support portion is positioned between the incidence face and the emission face.

7. The optical element holding device according to Claim 5, wherein
the groove portion has a first groove portion formed in a side face of the optical element and a second groove portion formed in a side face of the optical element, the first groove portion and the second groove portion are formed in a side face of the optical element, separated by a distance in a direction parallel to an optical axis;
the first support portion is inserted into the first groove portion; and,
the second support portion is inserted into the second groove portion, and, together with the first support portion, clamps a portion of the optical element.

8. The optical element holding device according to Claim 7, wherein the portion of the optical element comprises a rim portion formed between the first groove portion and the second groove portion.

9. A projection optical system that forms an image of a first plane onto a second plane, and comprising a plurality of optical elements, wherein, among the plurality of optical elements, at least one optical element is an optical element according to any one of Claims 1 to 4.

10. A projection optical system that forms an image of a first plane onto a second plane, and comprising a plurality of optical elements, further comprising an optical element holding device according to any one of Claims 5 to 8 as an optical element holding device which holds at least one optical element among the plurality of optical elements.

11. An exposure apparatus that irradiates a substrate with exposure light via an optical element to expose the substrate, wherein an optical element according to any one of Claims 1 to 4 is used as the optical element.

12. The exposure apparatus according to Claim 11, having a projection optical system through which the exposure light passes, and wherein the optical element is constituted of a portion of the projection optical system.

13. The exposure apparatus according to Claim 11 or 12, wherein the projection optical system has a first optical element which is closest to the image plane of the projection optical system and a second optical element which after the first optical element is closest to the image plane, and wherein the groove portion is provided in the second optical element.

14. The exposure apparatus according to any one of Claims 11 to 13, wherein a space between the first optical element and the second optical element is filled with a liquid.

15. The exposure apparatus according to any one of Claims 11 to 14, wherein the substrate is positioned on the image-plane side of the first optical element, and the space between the first optical element and the substrate is filled with a liquid.

16. An exposure apparatus that irradiates a substrate with exposure light via an optical element to expose the substrate, comprising an optical element holding device according to any one of Claims 5 to 8 to hold the optical element.

17. A device manufacturing method that uses the exposure apparatus according to any one of Claims 11 to 16.
